# EUROPEAN PATENT APPLICATION

(11) **EP 2 501 210 A2**
(43) Date of publication of application: **19.09.2012**
(21) Application number: 12159698.5
(22) Date of filing: 15.03.2012
(51) Int. Cl.: H05K 7/14

(54) **Power distribution unit and method of distributing high density power**

(30) Priority: 16.03.2011 US 201161453249 P
(71) Applicant: Hamilton Sundstrand Corporation, Windsor Locks, CT 06096-1010 (US)
(72) Inventor: Krenz, Michael, Roscoe, IL Illinois 61073 (US); Seger, Mark J., Rockford, IL Illinois 61108 (US); Wavering, Jeffrey T., Rockford, IL Illinois 61109 (US); Zwiefelhofer, Donald A., Rockford, IL Illinois 61107 (US); Vaziri, Massoud, Redmond, VA Virginia 98052 (US)
(74) Representative: Tomlinson, Kerry John

(57) **Abstract**

A power distribution (10) unit includes a first solid state power module (24) comprising a first plurality of solid state power controllers (26), where the first solid state power module comprises a first set of power characteristics. Also included is a second solid state power module (24) comprising a second plurality of solid state power controllers (26). The second solid state power module comprises a second set of power characteristics. Also, the first solid state power module and the second solid state power module are interchangeably coupled to a first location of a common chassis (30).

## Description

### BACKGROUND OF THE INVENTION

The present invention relates to power distribution systems, and more particularly to high density power systems and methods of high density power distribution.

Applications requiring power distribution often have severe space constraints for power distribution system components. An example of such an application is a vehicle, such as an aircraft. The limited space available for system components drives the requirement for high density power distribution. The power distribution system must be sufficiently compact, while still being adequately configured to distribute power to typically several loads. The loads include various types of protection against over-current, over and under-frequency, arc fault, and ground fault, to name a few potential sources of disruptions to load functionality. Circuit breaker panels are sized to attempt to fit into the space constrained areas, which are often unavailable during flight and are difficult to access on the ground, in the case of an aircraft.

### BRIEF DESCRIPTION OF THE INVENTION

According to one embodiment, a power distribution unit includes a first solid state power module comprising a first plurality of solid state power controllers, where the first solid state power module comprises a first set of power characteristics. Also included is a second solid state power module comprising a second plurality of solid state power controllers. The second solid state power module comprises a second set of power characteristics. Also, the first solid state power module and the second solid state power module are interchangeably coupled to a first location of a common chassis.

According to another embodiment, a method of distributing high density power is provided. The method includes packaging a first plurality of solid state power controllers to form a first solid state power module, where the first solid state power module comprises a first set of power characteristics. Also included is packaging a second plurality of solid state power controllers to form a second solid state power module, where the second solid state power module comprises a second set of power characteristics. Further included is selectively placing one of the first solid state power module and the second solid state power module within a first position of a chassis, where the first solid state power module and the second solid state power module are interchangeable. Yet further included is controlling one of the first solid state power module and the second solid state power module with a control interface.

### BRIEF DESCRIPTION OF THE DRAWINGS

The subject matter which is regarded as the invention is particularly pointed out and distinctly claimed in the claims at the conclusion of the specification. The foregoing and other features and advantages of the invention are apparent from the following detailed description taken in conjunction with the accompanying drawings in which:

FIG. 1 schematically illustrates a power distribution unit having a logic section and a power section;

FIG. 2 illustrates a block diagram of a plurality of solid state power modules;

FIG. 3 illustrates a block diagram of a power block arranged in a first configuration;

FIG. 4 illustrates a block diagram of the power block arranged in a second configuration; and

FIG. 5 is a flow diagram illustrating a method of distributing high density power.

### DETAILED DESCRIPTION OF THE INVENTION

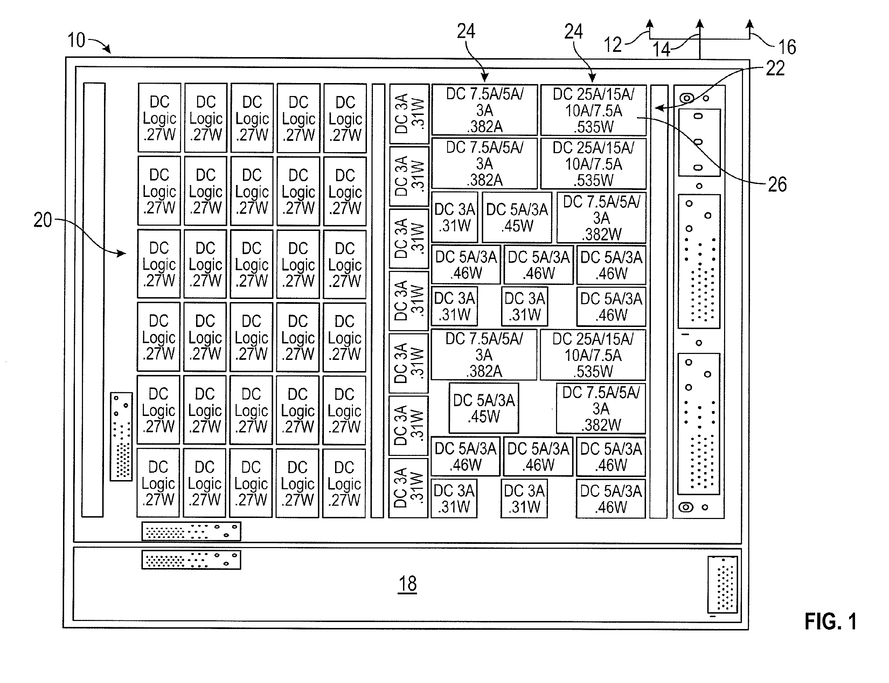

Referring to FIG. 1, a power distribution unit is generally schematically illustrated with reference numeral 10. The power distribution unit 10 may be employed in a variety of applications, such as an aircraft or another vehicle (not illustrated), for example. The vehicle includes a plurality of powered vehicle systems 12, 14, 16. The power distribution unit 10 provides power to the powered vehicle systems 12, 14, 16 and is supplied power by a power supply 18.

The power distribution unit 10 comprises a logic section 20 and a power section 22, with the power section 22 being made up, at least in part, by one or more solid state power modules (SSPMs) 24, each having a plurality of solid state power controllers (SSPCs) 26. The SSPCs 26 employ transistors to provide a switching function and use electronics to provide a circuit breaker function to protect wiring associated with the power vehicle systems 12, 14, 16. The SSPMs 24, based on the composition of SSPCs 26, provide a variety of system protections including, but not limited to, integrated current sensing, over-current, and over-temperature protection, to name simply a few illustrative examples. Individually, the SSPCs 26 function as arc fault protection, ground fault protection, and when used as part of a larger protection network, provide differential current protection. Each of the SSPCs 26 includes a power supply (not shown) that facilitates operation of the SSPCs 26. The SSPMs 24 include a first side and a second side and the SSPCs 26 are configured to mount to either the first side or the second side of the SSPMs 24, thereby providing a more compact packaging of the SSPCs 26 and making more efficient use of limited space provided for the power distribution unit 10. The plurality of SSPCs 26 that are mounted to, or packaged as, each SSPM 24 comprise a specific set of power characteristics for each SSPM 24. The power characteristics vary between distinct SSPMs 24 and provide various functionalities, depending on the assembly of SSPCs 26. In operation, the logic section 20 senses current at various locations proximate the SSPCs 26 to determine if appropriate functionality is occurring. In the event of a disruptive condition, the SSPCs 26 may be switched to an "off" condition. Specifically, the logic section 20 and the SSPCs 26 may include various components that are configured to receive and transmit data related to operation of the SSPCs 26, among other things. Such components may include microcontrollers and communications interfaces.

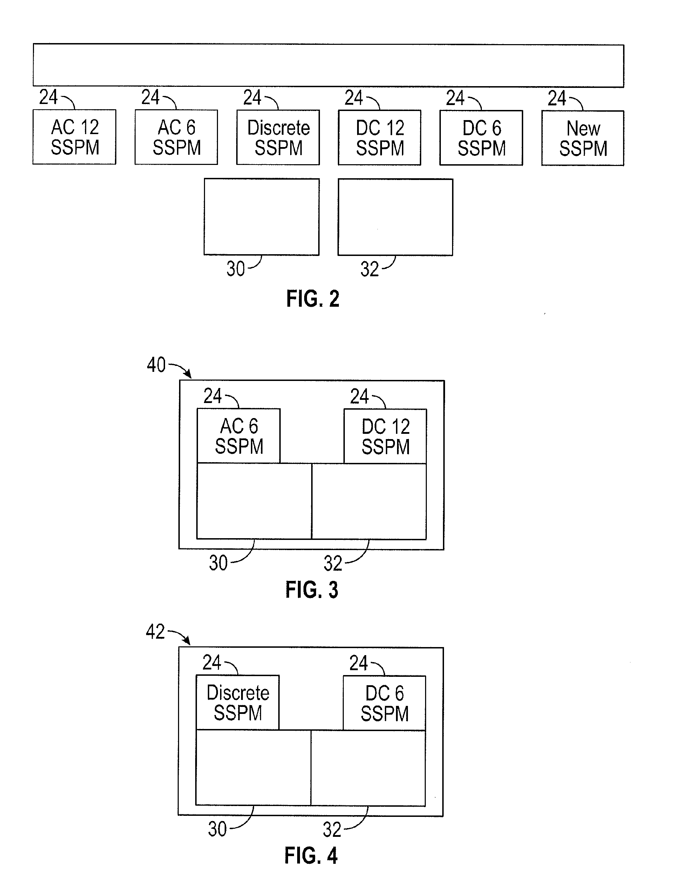

Referring to FIG. 2, one or more SSPMs 24 are placed within a common chassis 30 and a common backplane 32. As described above, SSPMs 24 having a variety of power characteristics are available for assembly and can be interchangeably used at various locations within the power distribution unit 10 (FIG. 1), and more specifically within the power section 22 (FIG. 1). The ability to selectively configure the SSPMs 24 having various power characteristics provides assembling flexibility and a more diverse set of power characteristics to employ in the power distribution unit 10. It is to be appreciated that the SSPMs 24 are reusable clusters that may be installed in various configurations on the common chassis 30 and the common backplane 32.

Referring to FIGS. 3 and 4, a first SSPM family 40 and a second SSPM family 42 are illustrated and it is shown that the first SSPM family 40 and the second SSPM family 42 each include distinct SSPMs 24 that are interchangeable, such that a first SSPM 24 could be positioned in replacement of a second SSPM 24, if an alteration of power characteristics for a particular application was desired. Irrespective of the particular installation configuration of the SSPMs 24, a consistent communication control interface is employed. By providing consistent communication control, regardless of the specific SSPM 24 arrangement, greater assembly flexibility is available without requiring rearrangement or alteration of the control interface. It is to be understood that the illustrated embodiments include two SSPMs, however, any number of SSPMs may be employed to comprise the SSPM family.

The SSPM families 40, 42 may be part of a power block that provides functionality within the power distribution unit 10. The term "power block" conceptually refers to hardware structure that functionally monitors and protects at least one load, but typically a plurality of load circuits. Nominally, this may include solid state power controllers (SSPCs), control logic, processing logic, internal communications busses, and power supplies to power various control elements. The protected load is any device that consumes power. This can be as simple as a resistive heating element in an air data probe, a light bulb disposed in the application, such as an aircraft, or as complex as a motor controller used to drive a hydraulic pump. By monitoring and controlling operating conditions that loads and power distribution units are encountering, the SSPCs 26 have the ability to quickly and flexibly switch power sources and limit or disrupt power to selected loads in the event of harmful operating conditions.

The power distribution unit 10 also includes a combination of remote data concentration modules and remote power control modules that are not in direct contact with the power distribution unit 10, but are in operable communication with the power distribution unit. The remote data concentration modules and the remote power control modules are configured to facilitate remote control of the various circuit protections that the power distribution unit 10 provides. This is particularly useful in applications such as the instant case, where the spaces in which the power distribution unit 10 is disposed may be difficult to access, or even completely inaccessible during operation.

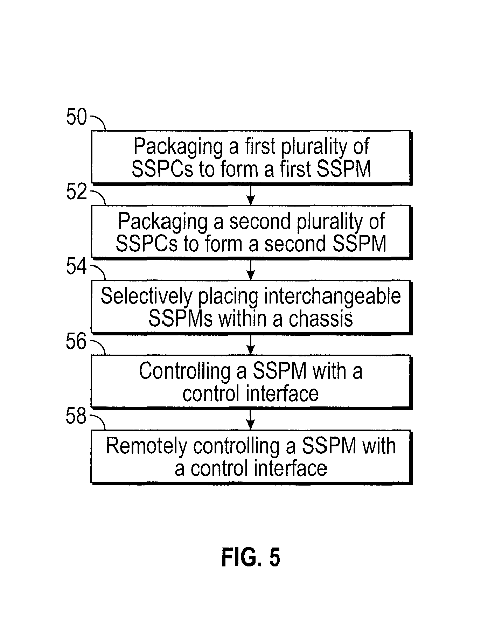

Referring to FIG. 5, a method of distributing high density power is illustrated. The power distribution unit 10 has been previously described and specific components need not be described in further detail. The method includes packaging a first plurality of SSPCs 50 to form a first SSPM. As described above, the specific SSPCs packaged to form the first SSPM provides a first set of power characteristics. Similarly, packaging a second plurality of SSPCs 52 to form a second SSPM provides a second set of power characteristics. Based on the application of use, at least one of the first SSPM and the second SSPM is selectively placed 54 within the chassis to form a power block. Irrespective of whether the first SSPM or the second SSPM is placed on a particular location of the chassis, the method includes controlling 56 a SSPM family with a control interface that provides consistent communication control. Additionally, the SSPM may be remotely controlled 58 with a remote data module and/or a remote power control module.

Accordingly, the previously described packaging scheme for the power distribution unit 10 adequately addresses tight spatial constraints imposed in certain applications, while also providing a consistent communication control with the control interface that communicates with the power block.

While the invention has been described in detail in connection with only a limited number of embodiments, it should be readily understood that the invention is not limited to such disclosed embodiments. Rather, the invention can be modified to incorporate any number of variations, alterations, substitutions or equivalent arrangements not heretofore described, but which are commensurate with the scope of the invention, which is defined by the claims. Additionally, while various embodiments of the invention have been described, it is to be understood that aspects of the invention may include only some of the described embodiments. Accordingly, the invention is not to be seen as limited by the foregoing description, but is only limited by the scope of the appended claims.

## Claims

1. A power distribution unit comprising:
a first solid state power module comprising a first plurality of solid state power controllers, wherein the first solid state power module comprises a first set of power characteristics; and
a second solid state power module comprising a second plurality of solid state power controllers, wherein the second solid state power module comprises a second set of power characteristics, wherein the first solid state power module and the second solid state power module are interchangeably coupled to a first location of a common chassis.

2. The power distribution unit of claim 1, further comprising a control interface in operable communication with the power distribution unit, wherein the control interface is configured to control the first solid state power module and the second solid state power module.

3. The power distribution unit of claim 2, further comprising a plurality of remote data concentration modules and a plurality of remote power control modules.

4. The power distribution unit of claim 3, wherein the control interface is configured to control the plurality of remote data concentration modules and the plurality of remote power control modules.

5. The power distribution unit of claim 1, 2, 3 or 4, wherein the solid state power module comprises a common backplane.

6. The power distribution unit of claim 5, wherein the first solid state power module includes a first side having at least one first side mounting component and a second side having at least one second side mounting component, wherein the first plurality of solid state power controllers are configured to mount to the first side and the second side.

7. The power distribution unit of claim 6, wherein the first solid state power module is mounted to the common chassis and the common backplane.

8. The power distribution unit of any preceding claim, further comprising a plurality of common chassis locations; preferably
wherein a plurality of interchangeable solid state power modules are interchangeably coupled to the plurality of common chassis locations.

9. A method of distributing high density power comprising:
packaging a first plurality of solid state power controllers to form a first solid state power module, wherein the first solid state power module comprises a first set of power characteristics;
packaging a second plurality of solid state power controllers to form a second solid state power module, wherein the second solid state power module comprises a second set of power characteristics;
selectively placing one of the first solid state power module and the second solid state power module within a first position of a chassis, wherein the first solid state power module and the second solid state power module are interchangeable; and
controlling one of the first solid state power module and the second solid state power module with a control interface.

10. The method of claim 9, wherein packaging the first plurality of solid state power controllers further comprises mounting a first solid state power controller to a first side of the first solid state power module and a second solid state power controller to a second side of the second solid state power module.

11. The method of claim 9 or 10, further comprising interchanging at least one alternate solid state power controllers with at least one of the first plurality of solid state power controllers.

12. The method of claim 9, 10 or 11, further comprising selectively packaging a plurality of solid state power modules to form a solid state power module family, wherein the solid state power module family comprises a plurality of alternative configurations.

13. The method of claim 12, further comprising controlling the power block with the control interface.

14. The method of any of claims 9 to 13, further comprising integrating at least one remote data module and at least one remote power control module.

15. The method of claim 14, further comprising controlling the at least one remote data module and the at least one remote power control module with the control interface.
